# EUROPÄISCHE PATENTANMELDUNG

(11) **EP 3 644 348 A1**
(43) Veröffentlichungstag der Anmeldung: **29.04.2020**
(21) Anmeldenummer: 18201898.6
(22) Anmeldetag: 23.10.2018
(51) Int. Cl.: H01L 21/48, H01L 21/60, B23K 35/02, H01L 23/15, H01L 23/373, H01L 23/482

(54) **VERFAHREN ZUR HERSTELLUNG EINES SUBSTRATS**

(71) Anmelder: Heraeus Deutschland GmbH & Co. KG, 63450 Hanau (DE)
(72) Erfinder: KLEIN, Andreas, 63450 Hanau (DE); MIRIC, Anton, 63450 Hanau (DE); LÖWER, Yvonne, 63450 Hanau (DE); RICHTER, Hans-Jürgen, 63450 Hanau (DE); PELSHAW, Nadja, 63450 Hanau (DE)
(74) Vertreter: Maiwald Patent- und Rechtsanwaltsgesellschaft mbH

(57) **Zusammenfassung**

Die vorliegende Erfindung betrifft ein Verfahren zur Herstellung eines Substrats, ein Substrat und ein Substratsystem. Das Verfahren zur Herstellung eines Substrats umfasst die folgenden Schritte: Bereitstellen eines Lotdepotplättchens mit mindestens einer Durchgangsöffnung, Bereitstellen einer Substratbasis, Einfügen von Klebstoffmaterial zwischen das Lotdepotplättchen und eine erste Oberfläche der Substratbasis, und Zusammenfügen des Lotdepotplättchens und der Substratbasis mit dazwischenliegendem Klebstoffmaterial. Beim Zusammenfügen des Lotdepotplättchens und der Substratbasis dringt das dazwischenliegende Klebstoffmaterial in die Durchgangsöffnung des Lotdepotplättchens ein und fixiert das Lotdepotplättchen auf der ersten Oberfläche der Substratbasis.

## Beschreibung

### Technisches Gebiet

Die vorliegende Erfindung betrifft ein Verfahren zur Herstellung eines Substrats, ein Substrat und ein Substratsystem. Insbesondere betrifft die vorliegende Erfindung ein Herstellungsverfahren für ein Substrat, auf das ein Elektronikbauteil aufgelötet werden kann.

### Hintergrund der Erfindung

Herkömmlicherweise werden Substrate hergestellt, indem auf eine Substratbasis ein Lotdepotelement geklemmt wird. Die Verklemmung dient als Fixierung für eine nachfolgende präzise Verlötung zwischen dem Lotdepotelement und der Substratbasis. Eine Verklemmung geschieht durch eine komplexe mechanische Aufspannvorrichtung, die designspezifisch ist, eine hohe thermische Masse aufweist und manuell bedient werden muss. Als Fixierung für eine nachfolgende präzise Verlötung zwischen dem Lotdepotelement und einem Elektronikbauteil kann erneut eine komplexe mechanische Aufspannvorrichtung mit den genannten Nachteilen verwendet werden. Ein solches Herstellungsverfahren ist eher umständlich und kostenintensiv.

### Zusammenfassung der Erfindung

Es ist daher eine Aufgabe der vorliegenden Erfindung, ein Verfahren zur Herstellung eines Substrats bereitzustellen, welches weniger aufwendig ist.

SE

Diese Aufgabe wird durch ein Verfahren zur Herstellung eines Substrats, ein Substrat und ein Substratsystem nach den unabhängigen Ansprüchen gelöst. Vorteilhafte Ausführungsformen und Weiterbildungen sind den Unteransprüchen und der nachfolgenden Beschreibung zu entnehmen.

Ein Verfahren gemäß der vorliegenden Erfindung zur Herstellung eines Substrats umfasst die folgenden Schritte:
- Bereitstellen eines Lotdepotplättchens mit mindestens einer Durchgangsöffnung,
- Bereitstellen einer Substratbasis,
- Einfügen von Klebstoffmaterial zwischen das Lotdepotplättchen und eine erste Oberfläche der Substratbasis, und
- Zusammenfügen des Lotdepotplättchens und der Substratbasis mit dazwischenliegendem Klebstoffmaterial.

Beim Zusammenfügen des Lotdepotplättchens und der Substratbasis dringt das dazwischenliegende Klebstoffmaterial in die Durchgangsöffnung des Lotdepotplättchens ein und fixiert das Lotdepotplättchen auf der ersten Oberfläche der Substratbasis.

Die Verklebung zwischen dem Lotdepotplättchen und der Substratbasis dient als Fixierung für eine nachfolgende präzise Verlötung zwischen dem Lotdepotplättchen und der Substratbasis. Durch die Durchgangsöffnung in dem Lotdepotplättchen steht das Klebstoffmaterial jedoch nicht nur zwischen dem Lotdepotplättchen und der Substratbasis zur Verfügung, sondern dringt auch durch das Lotdepotplättchen hindurch, sodass es auch auf der anderen, nicht der Substratbasis zugewandten Oberfläche des Lotdepotplättchens für eine spätere Verklebung mit einem Elektronikbauteil für eine weiter nachfolgende präzise Verlötung zwischen dem Lotdepotplättchen und dem Elektronikbauteil zur Verfügung steht. Der Vorteil des erfindungsgemäßen Verfahrens zur Herstellung eines Substrats liegt also darin, dass keine mechanischen Aufspannvorrichtungen mit den oben genannten Nachteilen verwendet werden müssen. Das mechanische Spannen wird durch eine Verklebung ersetzt und zusätzlich wird in einem Herstellungsschritt das Klebstoffmaterial durch die Durchgangsöffnung auf beiden Seiten des Lotdepotplättchens zur Verfügung gestellt. Es wird gegenüber dem Stand der Technik also ein zweistufiges Verklemmen durch nur einen Verklebungsschritt ersetzt. Das erfindungsgemäße Verfahren zur Herstellung eines Substrats ist daher gegenüber dem Stand der Technik deutlich weniger aufwendig und kostenintensiv. Teure mechanische Aufspannvorrichtungen sind nicht länger erforderlich. Weiterhin weist die Verklebung gegenüber einer mechanischen Aufspannvorrichtung eine erheblich geringere thermische Masse auf, was den Energiebedarf zum Verlöten deutlich reduziert. Als weitere Vorteile ist das erfindungsgemäße Herstellungsverfahren unabhängig vom Design und erfordert keine manuelle Bedienung. Das erfindungsgemäße Herstellungsverfahren kann auch gegenüber dem Stand der Technik robuster, sauberer und präziser sein, und somit Ausschuss reduzieren.

Das Substrat umfasst die Substratbasis, das Lotdepotplättchen und das Klebstoffmaterial.

Die Substratbasis kann ein beliebiges Trägermaterial sein. Sie kann flächenförmig ausgebildet sein und eine flache ebene Struktur aufweisen. Beispielsweise kann die Substratbasis ein zu bedruckendes oder ein zu beschichtendes Material oder in der Halbleitertechnik ein Ausgangsmaterial für eine Fertigung von Elektronikmodulen sein. Die Substratbasis kann für eine elektronische Anwendung geeignet sein, bei der ein elektronisches Bauteil beispielsweise ein Chip, ein Schalter, ein Beleuchtungselement, ein Kondensator, ein Widerstand oder ähnliches auf die Substratbasis aufgebracht wird.

Die Substratbasis kann eine erste und zweite Seite oder Oberfläche aufweisen, die jeweils als Unter- und Oberseite bezeichnet werden können. Die "Unterseite" kann eine Oberfläche der Substratbasis sein, auf welcher weder Lotdepotplättchen noch Klebstoffmaterial angeordnet ist. Im Gegensatz dazu kann eine "Oberseite" eine Oberfläche der Substratbasis sein, auf welche das Lotdepotplättchen und das Klebstoffmaterial appliziert sind. Die Durchgangsöffnung kann die Oberseite der Substratbasis mit der Unterseite des Lotdepotplättchens verbinden. Die Durchgangsöffnung kann im Querschnitt einen konstanten Durchmesser aufweisen oder sich in eine oder beide Richtungen kegelförmig aufweiten.

Die Substratbasis weist auf ihrer Oberfläche ein sogenanntes Lotdepotplättchen auf. Das Lotdepotplättchen ist ein Element, welches eine Lotpreform umfasst oder es ist eine Lotpreform. Die Lotpreform kann der Herstellung eines Lotdepots dienen, sie kann also erst durch eine Befestigung an der Substratbasis zum Lotdepot werden. Das Lotdepotplättchen kann ein Plättchen oder ein Scheibchen sein. Das Lotdepotplättchen kann je nach Einsatzzweck ein Metall oder mehrere verschiedene Metalle in bestimmten Mischungsverhältnissen umfassen oder daraus bestehen. Form, Größe und Dicke des Lotdepotplättchens können je nach Einsatzzweck variieren. Das Lotdepotplättchen kann eine Metall- oder Legierungsschicht sein. Das Lotdepotplättchen kann zum Beispiel SnAg3.5 umfassen. Form, Größe und Dicke des Lotdepotplättchens können je nach Einsatzzweck variieren. Das Lotdepotplättchen kann zum Beispiel eine Dicke zwischen 30 und 400 µm und bevorzugt zwischen 65 und 120 µm aufweisen. Bei einer Bodenplattenlötung kann die Dicke auch zwischen 200 und 400 µm liegen. Das Lotdepotplättchen kann beispielsweise für eine dauerhafte, feste Verbindung mit einem elektronischen Bauteil geeignet sein, beispielsweise indem es sich als Schmelze mit der Oberfläche des Bauteils verbindet bzw. legiert und nach Abkühlung erstarrt.

Zwischen das Lotdepotplättchen und die Substratbasis ist ein Klebstoffmaterial eingefügt, welches in die Durchgangsöffnung des Lotdepotplättchens eindringt und das Lotdepotplättchen auf der Oberfläche der Substratbasis fixiert, um einen darauffolgenden Lötvorgang zwischen der Substratbasis, dem Lotdepotplättchen und ggf. einem elektronischen Bauteil zu erleichtern. Dabei fixiert nur das Klebstoffmaterial das Lotdepotplättchen auf der Substratbasis, es gibt keine mechanischen, äußeren Befestigung- oder Spannvorrichtungen.

Das Zusammenfügen kann ein Zusammendrücken sein. Das Zusammenfügen bzw. das Zusammendrücken kann allein durch die Schwerkraft, manuell oder maschinell geschehen. Beim maschinellen Zusammenfügen kann eine Kraft beispielsweise im Bereich von 10 bis 500 g/mm² angewendet werden.

In einer Ausführungsform durchdringt das Klebstoffmaterial die Durchgangsöffnung und erreicht die von der Substratbasis abgewandte Seite bzw. die Oberseite des Lotdepotplättchens. Vorzugsweise quillt das Klebstoffmaterial aus der Durchgangsöffnung auf der von der Substratbasis abgewandten Seite bzw. aus der Oberseite des Lotdepotplättchens heraus und benetzt die von der Substratbasis abgewandte Seite bzw. die Oberseite des Lotdepotplättchens. Das Eindringen des Klebstoffmaterials in die Durchgangsöffnung bzw. das Durchdringen der Durchgangsöffnung bzw. das Herausquellen aus der Durchgangsöffnung stellt eine sehr einfache Möglichkeit dar, das Lotdepotplättchen an der Substratbasis zu fixieren, um ein späteres Verlöten mit einem Elektronikbauteil zu erleichtern.

In einer Ausführungsform weist das Lotdepotplättchen mehrere Durchgangsöffnungen auf. Mehrere Durchgangsöffnungen können eine gleichmäßige Verteilung des Klebstoffmaterial ermöglichen.

Die mehreren Durchgangsöffnungen können einfach und kostengünstig maschinell in einem Schritt hergestellt werden. Dies kann zum Beispiel durch Perforieren oder Schlitzen geschehen. In einer Ausführungsform umfasst das Bereitstellen des Lotdepotplättchens daher ein Bereitstellen eines Lotdepotausgangsmaterials und ein Perforieren des Lotdepotausgangsmaterials. Perforieren ist eine Durchlochung von flachen Gegenständen vorzugsweise mit regelmäßiger Anordnung, Anzahl, Form und/oder Größe der Durchgangsöffnungen. Das Perforieren kann durch Schneiden, Stanzen oder ähnliches geschehen. Mittels Perforieren oder Schlitzen kann aber auch eine einzelne Durchgangsöffnung pro Lotdepotplättchen hergestellt werden.

Die Durchgangsöffnung kann oder die Durchgangsöffnungen können kreisförmig, oval, langlochförmig, schlitzförmig, schneckenförmig und/oder Ähnliches sein. Im Falle von mehreren Durchgangsöffnungen können alle Durchgangsöffnungen dieselbe Form oder verschiedene Formen aufweisen.

In einer Ausführungsform ist das Einfügen des Klebstoffmaterials ein Aufbringen auf die Oberseite bzw. eine dem Lotdepotplättchen zugewandte Seite der Substratbasis. Zusätzlich oder alternativ kann das Einfügen des Klebstoffmaterials ein Aufbringen auf eine Unterseite bzw. auf eine der Substratbasis zugewandte Seite des Lotdepotplättchens sein. In einer Ausführungsform wird das Klebstoffmaterial in Form eines Klebepunkts bereitgestellt. Der Klebepunkt kann beispielsweise eine Fläche zwischen 1 und 20 mm² aufweisen. Der Klebepunkt kann beispielsweise eine Höhe zwischen 10 und 100 µm aufweisen.

In einer Ausführungsform ist das Klebstoffmaterial während eines Lötvorgangs flüchtig. Dies kann bedeuten, dass das Klebstoffmaterial beim Verlöten des elektronischen Bauteils mit der Substratbasis unzersetzt verdampft und/oder sich unter Zersetzung verflüchtigt, sodass keine oder keine störenden Rückstände verbleiben.

In einer Ausführungsform umfasst das erfindungsgemäße Herstellungsverfahren ein Fixieren eines Elektronikbauteils mit Hilfe des durchgedrungenen Klebstoffmaterials an der von der Substratbasis abgewandten Seite bzw. an der Oberseite des Lotdepotplättchens. Das Elektronikbauteil kann zum Beispiel ein Chip sein. Das Fixieren des Elektronikbauteils kann ein späteres Verlöten des Elektronikbauteils an der Substratbasis erleichtern.

In einer Ausführungsform umfasst das erfindungsgemäße Herstellungsverfahren auch ein Verlöten zur Befestigung des Elektronikbauteils an der Substratbasis. Es ist möglich in einem ersten Schritt das Lotdepotplättchen mit der Substratbasis zu verlöten und in einem zweiten Schritt das Lotdepotplättchen mit dem Elektronikbauteil zu verlöten. Es ist aber auch möglich, in einem einzigen Schritt das Elektronikbauteil, das Lotdepotplättchen und die Substratbasis miteinander zu verlöten.

In einer Ausführungsform umfasst das erfindungsgemäße Herstellungsverfahren vor dem Schritt des Zusammenfügens die folgenden Schritte:
- Bereitstellen eines weiteren Lotdepotplättchens mit mindestens einer Durchgangsöffnung, und
- Einfügen von Klebstoffmaterial zwischen das weitere Lotdepotplättchen und eine zweite Oberfläche der Substratbasis, die der ersten Oberfläche gegenüberliegt.
Auf diese Weise lässt sich auf einfache Art und Weise ein Substrat herstellen, bei dem auf beiden Seiten der Substratbasis jeweils zumindest ein Lotdepotplättchen angeordnet ist. Die erste Oberfläche der Substratbasis kann als Oberseite der Substratbasis verstanden werden und die zweite Oberfläche als die Unterseite der Substratbasis. Durch die beidseitigen Lotdepotplättchen kann auf jeder Seite der Substratbasis ein Elektronikbauteil oder auf einer Seite ein Elektronikbauteil und auf der anderen ein anderes Bauteil, beispielsweise eine Bodenplatte oder ein Kühlkörper, befestigt werden.

In einer Ausführungsform ist die Substratbasis ein Metallkeramikverbund. In einer Ausführungsform umfasst der Metallkeramikverbund eine Keramikschicht und eine oder zwei Metallisierungsschichten und eine oder beide Metallisierungsschichten weisen eine außenliegende Oberfläche auf, auf die ein Lotdepot aufgebracht werden kann. Der Begriff "Metallkeramikverbund" kann so verstanden werden, dass eine Substratbasis aus Keramik hergestellt und durch verschiedene Verfahren wie z.B. Direct-Copper-Bonding (üblicherweise als DCB-Verfahren bezeichnet), Direct-Aluminium-Bonding (üblicherweise als DAB-Verfahren bezeichnet) oder Active-Metal-Brazing (üblicherweise als AMB-Verfahren bezeichnet) metallisiert werden kann. Geeignete Materialien für die Keramiksubstratbasis sind beispielsweise ein Oxid, ein Nitrid, ein Carbid, oder ein Gemisch oder Komposit aus zumindest zweien dieser Materialien, insbesondere ggf. dotierte Aluminiumoxid- oder Siliziumnitrid-Keramik. Das nach der Metallisierung der Keramiksubstratbasis erhaltene Verbundmaterial wird auch als Metall-Keramik-Substrat oder Metall-Keramik-Verbund bezeichnet. Sofern es beispielsweise durch ein DCB-Verfahren hergestellt wurde, wird häufig auch die Bezeichnung "DCB-Substrat" verwendet.

Eine Metallisierung der Keramiksubstratbasis kann dadurch beispielsweise realisiert werden, dass zunächst eine Metallfolie oxidiert wird, sodass sich an deren Oberfläche eine Metalloxidschicht bildet. Die oxidierte Metallfolie wird auf die Keramiksubstratbasis aufgelegt und die Keramiksubstratbasis mit der oxidierten Metallfolie erhitzt. Der Metallkeramikverbund oder die Metallkeramiksubstratbasis kann eine feste Bindung der Metallbeschichtung an der Keramikoberfläche aufweisen, wobei diese Bindung auch unter längeren Temperaturwechselbelastungen ausreichend festbleiben soll. Eine Dicke der Metallisierungsschicht kann zum Beispiel zwischen 200 und 400 µm betragen.

Die Metallkeramiksubstratbasis kann eine Direct Copper Bonding (DCB) oder eine Direct Aluminium Bonding (DAB) Substratbasis sein, welche eine gute elektrische und thermische Verbindung elektronischer Bauteile und Chips über Kupfer bzw. Aluminium ermöglicht. In vielen Anwendungen der Leistungselektronik unterliegt eine Substratbasis Temperaturwechselbelastungen, bei denen deutliche Temperaturänderungen (z.B. im Bereich von -40 °C bis +150 °C) auftreten können. Die Direct Copper Bonding Substratbasis kann zum Beispiel Cu/Al₂O₃ umfassen.

Die vorliegende Erfindung umfasst weiterhin ein Substrat, welches umfasst:
- ein Lotdepotplättchen mit mindestens einer Durchgangsöffnung,
- eine Substratbasis, und
- ein Klebstoffmaterial.
Das Klebstoffmaterial ist zwischen dem Lotdepotplättchen und der Substratbasis angeordnet, in die Durchgangsöffnung des Lotdepotplättchens eingedrungen und fixiert das Lotdepotplättchen auf der Substratbasis.

Die vorliegende Erfindung umfasst weiterhin ein Substratsystem, welches eine Vielzahl der hier beschriebenen Substrate nebeneinander angeordnet umfasst. Dies kann als ein schachbrettartiges Feld von einzelnen, nebeneinander angeordneten Substraten verstanden werden.

Weitere Merkmale, Vorteile und Anwendungsmöglichkeiten der vorliegenden Erfindung ergeben sich aus der nachfolgenden Beschreibung, den Ausführungsbeispielen und den Figuren. Alle beschriebenen und/oder bildlich dargestellten Merkmale können unabhängig von ihrer Darstellung in einzelnen Ansprüchen, Figuren, Sätzen oder Absätzen miteinander kombiniert werden. In den Figuren stehen gleiche Bezugszeichen für gleiche oder ähnliche Objekte.

### Kurze Beschreibung der Figuren

Figur 1 zeigt ein Verfahren gemäß der vorliegenden Erfindung zur Herstellung eines Substrats.
Figur 2 zeigt ein Substrat gemäß der vorliegenden Erfindung.
Figur 3 zeigt ein weiteres Substrat gemäß der vorliegenden Erfindung.
Figur 4 zeigt ein Substratsystem gemäß der vorliegenden Erfindung.

### Detaillierte Beschreibung der Ausführungsbeispiele

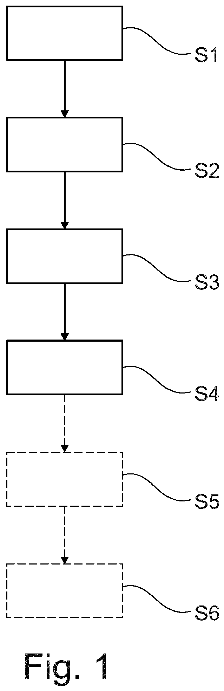

**Figur 1** zeigt ein Verfahren gemäß der vorliegenden Erfindung zur Herstellung eines Substrats 1 mit den folgenden Schritten:
- In einem Schritt S1,: Bereitstellen eines Lotdepotplättchens 2 mit mindestens einer Durchgangsöffnung 3. Das Lotdepotplättchen 2 kann auch mehrere Durchgangsöffnungen 3 aufweisen. Die Durchgangsöffnung 3 kann oder die Durchgangsöffnungen 3 können kreisförmig, oval, langlochförmig, schlitzförmig, schneckenförmig und/oder ähnliches sein.
- In einem Schritt S2,: Bereitstellen einer Substratbasis 10.
- In einem Schritt S3,: Einfügen von Klebstoffmaterial 4 zwischen das Lotdepotplättchen 2 und eine erste Oberfläche 11 der Substratbasis 10. Das Einfügen des Klebstoffmaterials 4 kann ein Aufbringen auf die Oberseite bzw. eine dem Lotdepotplättchen 2 zugewandte Seite der Substratbasis 10 sein. Zusätzlich oder alternativ kann das Einfügen des Klebstoffmaterials 4 ein Aufbringen auf eine Unterseite bzw. auf eine der Substratbasis 10 zugewandte Seite des Lotdepotplättchens 2 sein.
- In einem Schritt S4,: Zusammenfügen des Lotdepotplättchens 2 und der Substratbasis 10 mit dazwischenliegendem Klebstoffmaterial 4. Beim Zusammenfügen des Lotdepotplättchens 2 und der Substratbasis 10 dringt das dazwischenliegende Klebstoffmaterial 4 in die Durchgangsöffnung 3 des Lotdepotplättchens 2 ein und fixiert das Lotdepotplättchen 2 auf der ersten Oberfläche 11 der Substratbasis 10.

Der Schritt S1 kann ein Bereitstellen eines Lotdepotausgangsmaterials und ein Perforieren des Lotdepotausgangsmaterials umfassen. Perforieren ist eine Durchlochung von flachen Gegenständen vorzugsweise mit regelmäßiger Anordnung, Anzahl, Form und/oder Größe der Durchgangsöffnungen 3. Das Perforieren kann durch Schneiden, Stanzen oder ähnliches geschehen.

Das Zusammenfügen im Schritt S4 kann ein Zusammendrücken sein. Die Verklebung zwischen dem Lotdepotplättchen 2 und der Substratbasis 10 dient als Fixierung für eine nachfolgende präzise Verlötung zwischen dem Lotdepotplättchen 2 und der Substratbasis 10. Das Klebstoffmaterial 4 dringt in die Durchgangsöffnung 3 des Lotdepotplättchens 2 ein und steht dann auch auf der gegenüberliegenden Oberfläche des Lotdepotplättchens 2 für eine Verklebung zur Verfügung.
- In einem Schritt S5,: optionales Fixieren eines Elektronikbauteils 5 mit Hilfe des durchgedrungenen Klebstoffmaterials 4 an der von der Substratbasis 10 abgewandten Seite bzw. an der Oberseite des Lotdepotplättchens 2.
- In einem Schritt S6,: optionales Verlöten des fixierten Elektronikbauteils 5 und der Substratbasis 10 mittels des dazwischenliegenden Lotdepotplättchens 2. Das Klebstoffmaterial 4 kann während des Lötvorgangs flüchtig sein und daher beim Verlöten des elektronischen Bauteils mit der Substratbasis 10 unzersetzt verdampfen und/oder sich unter Zersetzung verflüchtigen.

Durch die Durchgangsöffnung 3 in dem Lotdepotplättchen 2 steht das Klebstoffmaterial 4 nicht nur zwischen dem Lotdepotplättchen 2 und der Substratbasis 10 zur Verfügung, sondern dringt auch durch das Lotdepotplättchen 2 hindurch, sodass es auch auf der anderen, nicht der Substratbasis 10 zugewandten Oberfläche des Lotdepotplättchens 2 für eine Verklebung mit einem Elektronikbauteil 5 zur Fixierung (Schritt S5) für eine weiter nachfolgende präzise Verlötung (Schritt S6) zwischen dem Lotdepotplättchen 2 und dem Elektronikbauteil 5 zur Verfügung steht. Es kann also in einem einzigen Schritt (S4 und S5) der gesamte Stapel aus Substratbasis 10, Lotdepotplättchen 2 und Elektronikbauteil 5 relativ zueinander fixiert werden. Danach kann in einem einzigen Schritt (S6) der gesamte Stapel aus Substratbasis 10, Lotdepotplättchen 2 und Elektronikbauteil 5 miteinander verlötet werden. Das Elektronikbauteil 5 kann ein Chip, ein Schalter, ein Beleuchtungselement, ein Kondensator, ein Widerstand oder ähnliches sein.

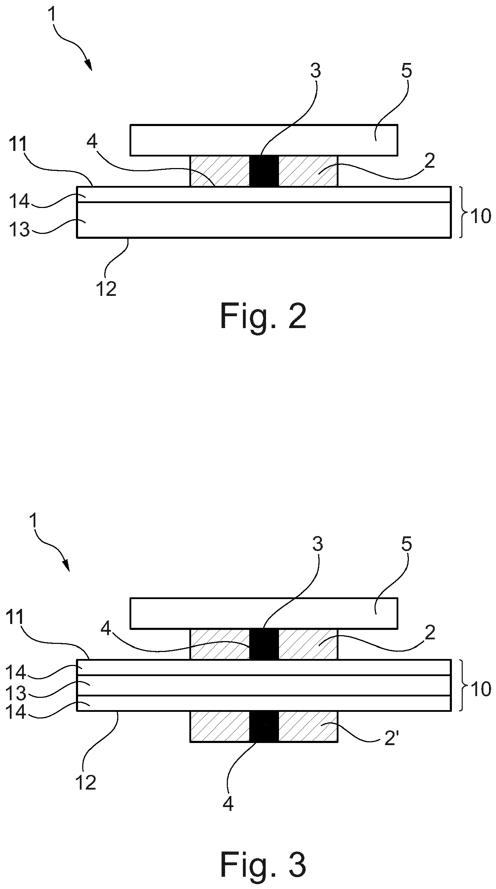

**Figur 2** zeigt ein Substrat 1 gemäß der vorliegenden Erfindung. Das Substrat 1 umfasst ein Lotdepotplättchen 2 mit mindestens einer Durchgangsöffnung 3, eine Substratbasis 10 und ein Klebstoffmaterial 4.

Die Substratbasis 10 weist eine flache ebene Struktur auf. Die Substratbasis 10 weist eine erste und zweite Seite auf, die jeweils als Unter- und Oberseite bezeichnet werden können. Die "Unterseite" ist eine Oberfläche 12 der Substratbasis 10, auf welcher hier weder Lotdepotplättchen 2 noch Klebstoffmaterial 4 angeordnet ist. Im Gegensatz dazu ist eine "Oberseite" eine Oberfläche 11 der Substratbasis 10, auf welche das Lotdepotplättchen 2 und das Klebstoffmaterial 4 appliziert sind. Die Substratbasis 10 ist ein Metallkeramikverbund aus einer Keramikschicht 13 und einer Metallisierungsschicht 14. Das Lotdepotplättchen 2 ist auf die Metallisierungsschicht 14 aufgebracht. Die Substratbasis 10 kann auch zwei Metallisierungsschichten aufweisen, nämlich die Metallisierungsschicht 14 und eine nicht gezeigte weitere Metallisierungsschicht auf der anderen Seite der Keramikschicht 13. Die Substratbasis 10 ist z.B. durch Direct-Copper-Bonding (üblicherweise als DCB-Verfahren bezeichnet) hergestellt.

Die Substratbasis 10 weist auf ihrer Oberfläche 11 das sogenannte Lotdepotplättchen 2 auf. Das Lotdepotplättchen 2 ist ein Element, welches eine Lotpreform umfasst.

Die Durchgangsöffnung 3 verbindet die Oberseite mit der Unterseite des Lotdepotplättchens 2. Das Lotdepotplättchen 2 kann mehrere Durchgangsöffnungen 3 aufweisen. Jede Durchgangsöffnung 3 kann beliebige Querschnitte aufweisen.

Das Klebstoffmaterial 4 ist zwischen dem Lotdepotplättchen 2 und der Substratbasis 10 angeordnet, in die Durchgangsöffnung 3 des Lotdepotplättchens 2 eingedrungen und fixiert das Lotdepotplättchen 2 auf der Substratbasis 10. In anderen Worten, das Klebstoffmaterial 4 durchdringt die Durchgangsöffnung 3 und erreicht die von der Substratbasis 10 abgewandte Seite bzw. die Oberseite des Lotdepotplättchens 2. Vorzugsweise quillt das Klebstoffmaterial 4 aus der Durchgangsöffnung 3 auf die von der Substratbasis 10 abgewandte Seite bzw. aus der Oberseite des Lotdepotplättchens 2 heraus und benetzt die von der Substratbasis 10 abgewandte Seite bzw. die Oberseite des Lotdepotplättchens 2. Das Eindringen des Klebstoffmaterials 4 in die Durchgangsöffnung 3 bzw. das Durchdringen der Durchgangsöffnung 3 bzw. das Herausquellen aus der Durchgangsöffnung 3 stellt eine sehr einfache Möglichkeit dar, das Lotdepotplättchen 2 an der Substratbasis 10 zu fixieren, um ein späteres Verlöten zwischen der Substratbasis 10, dem Lotdepotplättchen 2 und ggf. auch einem Elektronikbauteil 5 zu erleichtern.

**Figur 3** zeigt ein weiteres Substrat 1 gemäß der vorliegenden Erfindung. Wie in der Figur 2 weist das Substrat 1 ein Lotdepotplättchen 2 mit mindestens einer Durchgangsöffnung 3, eine Substratbasis 10 und ein Klebstoffmaterial 4 auf. Zusätzlich weist das Substrat 1 ein weiteres Lotdepotplättchen 2' mit mindestens einer Durchgangsöffnung 3 auf. Es ist Klebstoffmaterial 4 zwischen das weitere Lotdepotplättchen 2' und eine zweite Oberfläche 12 der Substratbasis 10, die der ersten Oberfläche 11 gegenüberliegt, eingefügt. Es ist also auf beiden Seiten der Substratbasis 10 jeweils ein Lotdepotplättchen 2,2' angeordnet. Die erste Oberfläche 11 der Substratbasis 10 kann als Oberseite der Substratbasis 10 verstanden werden und die zweite Oberfläche 12 kann als die Unterseite der Substratbasis 10 verstanden werden. Durch die beidseitigen Lotdepotplättchen 2,2' kann auf jeder Seite der Substratbasis 10 ein Elektronikbauteil 5 befestigt werden.

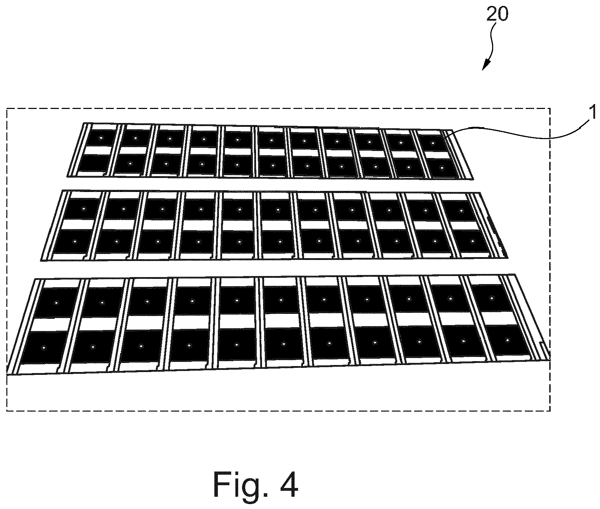

**Figur 4** zeigt ein Substratsystem 20 gemäß der vorliegenden Erfindung, welches eine Vielzahl der hier beschriebenen Substrate nebeneinander angeordnet umfasst.

Der Vorteil der Erfindung liegt darin, dass das konventionelle mechanische Spannen durch eine Verklebung ersetzt wird und zusätzlich in einem Herstellungsschritt das Klebstoffmaterial 4 gleichzeitig auf beiden Seiten des Lotdepotplättchens 2 bereitgestellt werden kann. Es wird gegenüber dem Stand der Technik also ein zweistufiges Verklemmen durch nur einen Verklebungsschritt ersetzt. Das erfindungsgemäße Herstellungsverfahren und das Substrat 1 sind daher gegenüber dem Stand der Technik deutlich weniger aufwendig und kostenintensiv. Teure mechanische Aufspannvorrichtungen sind nicht länger erforderlich. Weiterhin weist die Verklebung gegenüber einer mechanischen Aufspannvorrichtung eine erheblich geringere thermische Masse auf, was den Energiebedarf zum Verlöten deutlich reduziert. Als weitere Vorteile ist das erfindungsgemäße Herstellungsverfahren unabhängig vom Design und erfordert keine manuelle Bedienung.

Ergänzend sei darauf hingewiesen, dass "umfassend" und "aufweisend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

## Patentansprüche

1. Ein Verfahren zur Herstellung eines Substrats (1), umfassend die folgenden Schritte:
- Bereitstellen eines Lotdepotplättchens (2) mit mindestens einer Durchgangsöffnung (3),
- Bereitstellen einer Substratbasis (10),
- Einfügen von Klebstoffmaterial (4) zwischen das Lotdepotplättchen (2) und eine erste Oberfläche (11) der Substratbasis (10), und
- Zusammenfügen des Lotdepotplättchens (2) und der Substratbasis (10) mit dazwischenliegendem Klebstoffmaterial (4),
wobei beim Zusammenfügen des Lotdepotplättchens (2) und der Substratbasis (10) das dazwischenliegende Klebstoffmaterial (4) in die Durchgangsöffnung (3) des Lotdepotplättchens (2) eindringt und das Lotdepotplättchen (2) auf der ersten Oberfläche (11) der Substratbasis (10) fixiert.

2. Verfahren nach Anspruch 1, wobei das Klebstoffmaterial (4) die Durchgangsöffnung (3) durchdringt und die von der Substratbasis (10) abgewandte Seite des Lotdepotplättchens (2) erreicht.

3. Verfahren nach dem vorherigen Anspruch, weiterhin umfassend ein Fixieren eines Elektronikbauteils (5) mit Hilfe des durchgedrungenen Klebstoffmaterials (4) an der von der Substratbasis (10) abgewandten Seite des Lotdepotplättchens (2).

4. Verfahren nach dem vorherigen Anspruch, weiterhin umfassend ein Verlöten zur Befestigung des Elektronikbauteils (5) an der Substratbasis (10).

5. Verfahren nach einem der vorherigen Ansprüche, wobei das Lotdepotplättchen (2) mehrere Durchgangsöffnungen (3) aufweist.

6. Verfahren nach dem vorherigen Anspruch, wobei das Bereitstellen des Lotdepotplättchens (2) ein Bereitstellen eines Lotdepotausgangsmaterials und ein Perforieren des Lotdepotausgangsmaterials umfasst.

7. Verfahren nach einem der vorherigen Ansprüche, wobei die Durchgangsöffhung(en) (3) kreisförmig, oval, langlochförmig, schlitzförmig und/oder schneckenförmig ist/sind.

8. Verfahren nach einem der vorherigen Ansprüche, wobei das Einfügen des Klebstoffmaterials (4) ein Aufbringen auf eine dem Lotdepotplättchen (2) zugewandte Seite der Substratbasis (10) und/oder ein Aufbringen auf eine der Substratbasis (10) zugewandte Seite des Lotdepotplättchens (2) ist.

9. Verfahren nach einem der vorherigen Ansprüche, wobei das Verfahren vor dem Schritt des Zusammenfügens die folgenden Schritte umfasst:
- Bereitstellen eines weiteren Lotdepotplättchens (2') mit mindestens einer Durchgangsöffnung (3), und
- Einfügen von Klebstoffmaterial (4) zwischen das weitere Lotdepotplättchen und eine zweite Oberfläche (12) der Substratbasis (10), die der ersten Oberfläche (11) gegenüberliegt.

10. Verfahren nach einem der vorherigen Ansprüche, wobei das Klebstoffmaterial (4) während eines Lötvorgangs flüchtig ist.

11. Verfahren nach einem der vorherigen Ansprüche, wobei das Klebstoffmaterial (4) in Form eines Klebepunkts bereitgestellt wird.

12. Verfahren nach einem der vorherigen Ansprüche, wobei die Substratbasis (10) ein Metallkeramiksubstrat ist.

13. Verfahren nach dem vorherigen Anspruch, wobei das Metallkeramiksubstrat eine Keramikschicht (13) und mindestens eine Metallisierungsschicht (14) umfasst und die Metallisierungsschicht (14) dem Lotdepotplättchen (2) zugewandt ist.

14. Ein Substrat, umfassend:
- ein Lotdepotplättchen (2) mit mindestens einer Durchgangsöffnung (3),
- eine Substratbasis (10), und
- ein Klebstoffmaterial (4),
welches zwischen dem Lotdepotplättchen (2) und der Substratbasis (10) angeordnet ist, in die Durchgangsöffnung (3) des Lotdepotplättchens (2) eingedrungen ist und das Lotdepotplättchen (2) auf der Substratbasis (10) fixiert.

15. Ein Substratsystem (20) umfassend eine Vielzahl von nebeneinander angeordneten Substraten nach dem vorherigen Anspruch.
